# EUROPEAN PATENT APPLICATION

(11) **EP 3 113 207 A1**
(43) Date of publication of application: **04.01.2017**
(21) Application number: 15174195.6
(22) Date of filing: 29.06.2015
(51) Int. Cl.: H01J 37/22

(54) **INTEGRATED LIGHT OPTICS AND GAS DELIVERY IN A CHARGED PARTICLE LENS**

(71) Applicant: FEI Company, Hillsboro, OR 97124-5793 (US)
(72) Inventor: Parker, N. William, Hillsboro, OR Oregon 97124 (US); Straw, Marcus, Portland, OR Oregon 97212 (US); Filevich, Jorge, portland, OR Oregon 97210 (US); Botman, Aurélien, Portland, OR Oregon 97229 (US); Utlaut, Mark, Scappoose, OR Oregon 97056 (US); Randolph, Steven, Portland, OR Oregon 97209 (US); Chandler, Clive, Portland, OR Oregon 97212 (US)
(74) Representative: Bakker, Hendrik

(57) **Abstract**

A method and apparatus for directing light or gas or both to a specimen positioned within about 2 mm from the lower end of a charged particle beam column. The charged particle beam column assembly includes a platform defining a specimen holding position and has a set of electrostatic lenses each including a set of electrodes. The assembly includes a final electrostatic lens that includes a final electrode that is closest to the specimen holding position. This final electrode defines at least one internal passageway having a terminus that is proximal to and directed toward the specimen holding position.

## Description

### Technical Field of the Invention

The present invention relates to charged particle beam column assemblies. More specifically the present invention relates to charged particle beam column assemblies in which the specimen is held within 2 mm of the bottom of the column.

### Background of the Invention

A charged particle beam column directs a beam of charged particles to a specimen supported on a stage, for machining or imaging the specimen. Often, two charged particle beam columns are used in tandem (a "dual beam system"), with an electron beam being used for imaging and a focused ion beam being used for machining. Typically, in a dual beam system, there is a gap of at least 13 mm between the lower end of either column and the specimen. This gap permits a light source placed to the side of the column to shine light obliquely on the specimen. Also, one or more gas nozzles can be introduced into the gap, to introduce desired gasses directly toward the specimen.

Recently, it has been perceived that an advantage could be obtained by placing the end of the column much closer to the specimen, and by making the end of the column flat, rather than conical. This design concept, however, prevents gas from being delivered to the specimen because there is no place for a gas nozzle in the small gap between column and specimen. Likewise, light from a light source to the side of the column would be blocked from reaching the specimen, by the bottom of the column. As there are some production techniques that require light or gas or both to be delivered to a specimen, the design concept cannot be practical unless some way is found to deliver these elements to the specimen, despite the presence of the lower end of the column, so close to the specimen.

### Summary of the Invention

This invention comprises a method and apparatus for directing light or gas or both to a specimen positioned within about 2 mm from the lower end of a charged particle beam column. The charged particle beam column assembly includes a platform defining a specimen holding position and has a set of electrostatic lenses each including a set of electrodes. The assembly includes a final electrostatic lens that includes a final electrode that is closest to the specimen holding position. This final electrode defines at least one internal passageway having a terminus that is proximal to and directed toward the specimen holding position. Some embodiments provide more than one passageway, for directing two different gasses to the specimen, or for bringing light both to the specimen, and away from the specimen. In a further embodiment both gas passageways and light passageways are provided. Methods of use include using the passageways to direct light or gas or both to the specimen, and to direct light away from the specimen, during either imaging or machining.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention. It should also be realized by those skilled in the art that such equivalent constructions do not depart from the scope of the invention as set forth in the appended claims.

### Brief Description of the Drawings

For a more thorough understanding of the present invention, and advantages thereof, reference is now made to the following descriptions taken in conjunction with the accompanying drawings, in which:
FIG. 1 shows a cut-away view of a focused ion beam column, with the greater extent of the column shown in general outer form, but with the final electrode of the final lens partially cut-away to be shown in vertical cross-section and vertically expanded view, to reveal passageways;
FIG. 2 shows a vertical sectional view of a focused ion beam column, in which embodiments of the present invention could be implemented;
FIG. 3 shows a vertical sectional view of a bottom portion of a charged particle beam column, showing light passageways, according to an aspect of the present invention;
FIG. 4 shows a horizontal sectional view of a final electrode of a charged particle beam, showing multiple light passageways, according to one aspect of the present invention;
FIG. 5 shows a horizontal sectional view of a final electrode of a charged particle beam, showing two broad light passageways, in an alternative to the embodiment of FIG. 4;
FIG. 6 shows a vertical sectional view of a bottom portion of a charged particle beam column, showing gas passageways, according to an aspect of the present invention; and
FIG. 7 shows a horizontal sectional view of the final electrode shown as part of FIG. 6, also showing the gas passageways.

### Detailed Description of Preferred Embodiments

Embodiments of the present invention are directed to a charged particle beam column having a final electrode that permits light or gas or both to be directed to or from a specimen.

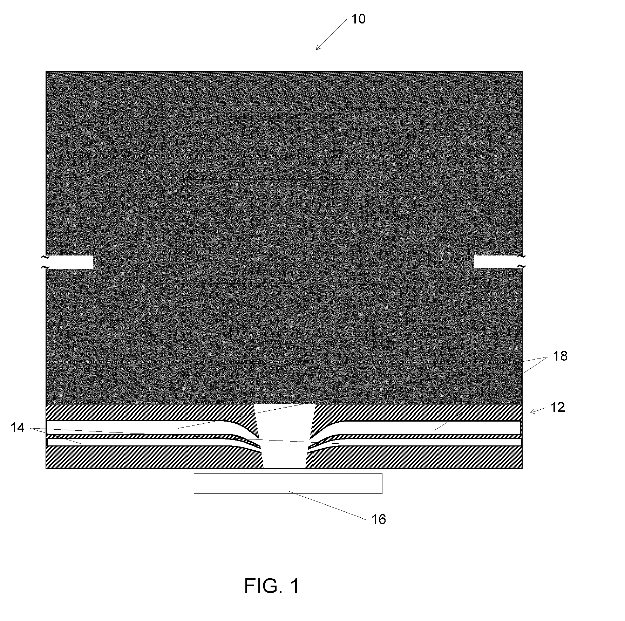

FIG. 1 shows a cut-away view of a charged particle beam column 10, so that the greater extent of the column 10 is in general outer form, but with the final electrode 12 of the final lens shown in sectional view and having greatly expanded vertical extent relative to rest of column 10, which is shown in truncated form. In broad overview, a charged particle column 10 has a final electrode 12 that has been machined to include a set of passageways 14, for transmitting light to or from a specimen 16, and a separate set of passageways 18, for permitting a gas or two different gasses to be delivered to the specimen 16. As will be detailed further below, more than one passageway may be created in transverse dimension. Also, the light passageways may include light pipes. By bringing light or gas or both to or from specimen 16, through the final electrode 12, it is possible to bring the final electrode within a 2 mm distance of specimen 16, without sacrificing machining or imaging capability.

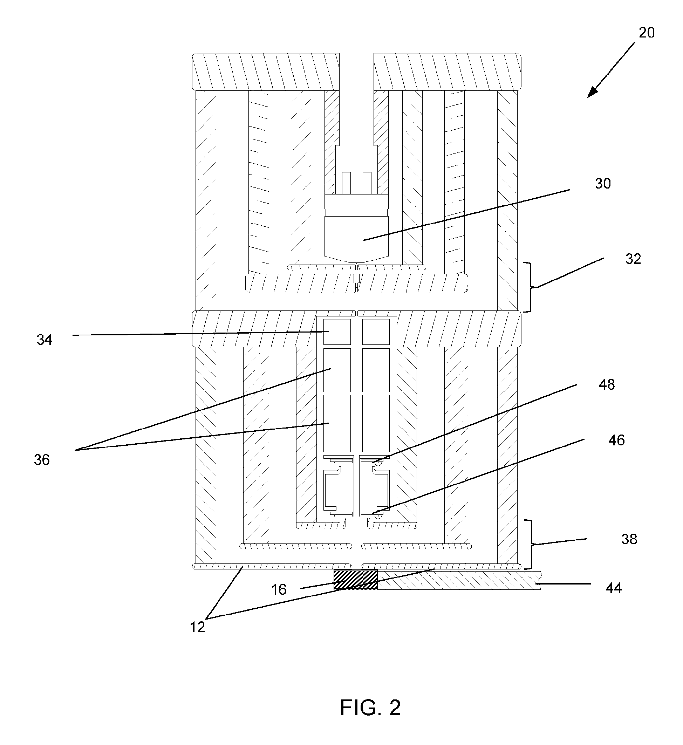

Referring to FIG. 2, which provides context for the embodiments disclosed herein by showing a charged particle beam column 20. A standard Schottky source 30 produces a charged particle stream, which is focused by a gun lens 32, before travelling, when not blanked, through a blanker 34, and a set of deflectors 36. Then, the charged particle beam passes through a main lens 38, which includes a final electrode 12, closest to the specimen. Finally, the beam reaches the specimen position 16, defined by the position of a specimen holder 44. A backscattered electron detector 46 detects higher energy (> 50 eV) electrons that are reflected or emitted from the specimen. Likewise a secondary electron detector 48 detects low energy (< 50 eV) electrons that are emitted from the specimen.

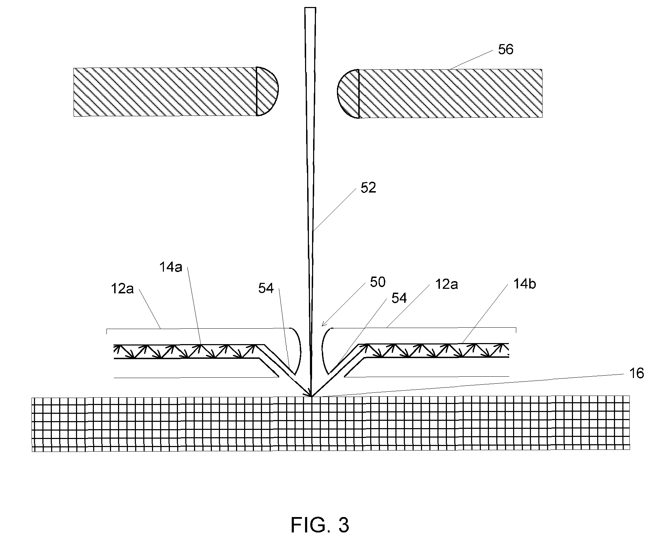

Referring to FIG. 3, in a preferred embodiment the final electrode 12a defines an aperture 50 that permits the passage of charged particle beam 52, and includes a first light passageway 14a, and a second light passageway 14b. Light passageway 14a is used to transmit light to the specimen position 16, whereas light passageway 14b is used to transmit light away from the specimen, although these roles are not fixed and could be changed. Electrode 12a may be made of metal, and more particularly of a titanium alloy, and in this case light passageways may be void, tubular spaces with polished interior surfaces, so that light can reflect between the surfaces in an intended path. Both light passageways 14a and 14b have a terminus 54 that is proximal to and directed toward the specimen position. The electrode 56 immediately above the final electrode 12a is also shown. In one preferred embodiment light passageways are light pipes that have been introduced into void spaces created in electrode 12a.

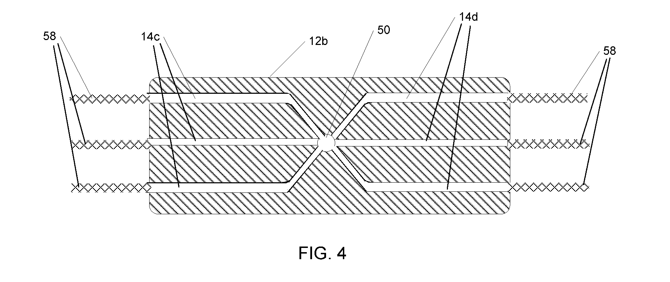

Referring to FIG. 4, which is a top view of a final electrode 12b, a set of three generally parallel light paths 14c permit light to travel toward the specimen position 16, while three generally parallel light paths 14d permit light to travel away from the specimen position 16. A set of light pipes 58 transmit light to and from paths 14c and 14d, respectively. Aperture 50 permits the charged particle beam, and the light, to reach the specimen 16 and to be collected from the specimen 16.

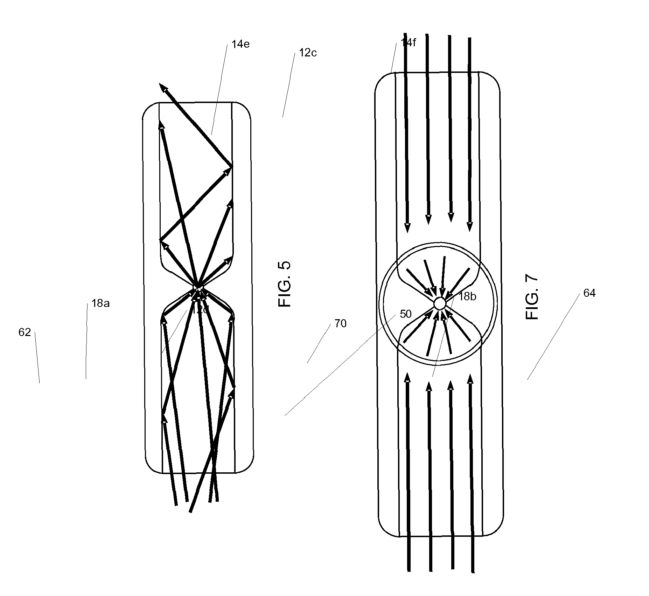

Referring to FIG. 5, in an alternative preferred embodiment, a final electrode 12c defines a single, wider pair of light paths 14e and 14f, which transmit light to and from the specimen position 16, respectively. Both passageways 14e and 14f reduce in width as they approach specimen position 16, thereby directing the light toward the specimen. On either side of final electrode 12c a wide light pipe may be used to transmit light to or away from light paths 14e and 14f, respectively.

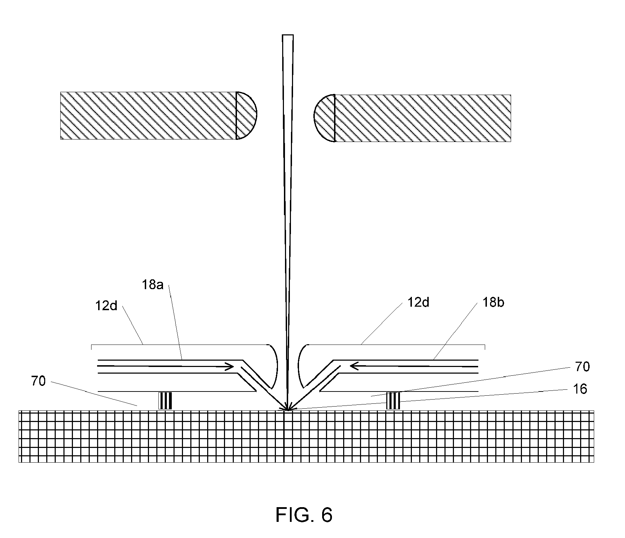

FIGS. 6 and 7 illustrate an embodiment in which a final electrode 12d defines first and second gas passageways 18a and 18b, for delivering a first gas 62 and a second gas 64 to the specimen 16, directly beneath aperture 50. A gas containment barrier 70, which is not present in an alternative preferred embodiment, prevents toxic gas from escaping. In an alternative embodiment, nozzles are attached at the openings closest to specimen 16, to more accurately direct the gas to a particular point.

In a further preferred embodiment, any of a passageways 14a-14f may serve as both a gas passageway and a light passageway, either simultaneously, in the event a clear gas is being delivered or in different instances of use.

According to some embodiments of the present invention, a charged particle beam column assembly comprises a platform defining a specimen holding position; a set of electrostatic lenses each including a set of electrodes, and including a final electrostatic lens that includes a final electrode that is closest to the specimen holding position; characterized in that said final electrode defines at least one internal passageway having a terminus that is proximal to and directed toward the specimen holding position.

In some embodiments, said at least one internal passageway comprises a light pathway and includes an additional terminus that houses a light detector; or said at least one internal passage way comprises a gas pathway and includes an additional terminus that is connected to a gas source. In some embodiments, said at least one internal passageway comprises a first light pathway and wherein said final electrode defines a second light pathway in addition to said first light pathway; or said at least one internal passageway comprises a first gas pathway and wherein said final electrode defines a second gas pathway in addition to said first gas pathway. In some embodiments, said first light pathway terminates in a light source and said second light pathway terminates in a light detector; or said first gas pathway terminates in a gas source and said second gas pathway terminates in a gas detector or a second gas source.

In some embodiments, said final electrode is made of metal and wherein said internal passageway takes the form of a tubular void space in the metal. In some embodiments, the metal comprises a titanium alloy. In some embodiments, the surfaces of the void space are polished to increase reflection. In some embodiments, the assembly further comprises a light pipe extending through said at least one internal passageway. In some embodiments, said at least one internal passageway comprises both a gas pathway and a light pathway and includes a terminus that communicates with both a gas source and a light source.

According to some embodiments of the present invention, a method of directing one or more of light or gas to a predetermined specimen position that is so close to a plate electrode that no oblique pathway exists under the plate electrode to a viable light source position, comprises emitting one or more of light or gas into one or more of a light pathway or a gas pathway; characterized by providing one or more of the light pathway or the gas pathway through the plate electrode to the predetermined specimen position.

In some embodiments, an additional light path is provided to the predetermined specimen position and wherein the method further includes receiving light from the specimen through the additional light path. In some embodiments, said light path is an interior void having polished surfaces, and wherein said light reflects from said polished surfaces as it travels to said specimen. In some embodiments, the final electrode is made of a titanium alloy.

In some embodiments, at least on additional light path is provided and wherein light is emitted into the at least one additional light path. In some embodiments, the gas pathway is a first gas pathway and wherein the gas is a first gas, and further wherein a second gas pathway is provided through the plate electrode to the predetermined specimen position and a second gas is passed through the second gas pathway.

We claim as follows:

## Claims

1. A charged particle beam column assembly, comprising:
a platform (16, 44) defining a specimen holding position;
a set of electrostatic lenses each including a set of electrodes, and including a final electrostatic lens that includes a final electrode (12, 12a, 12b, 12c, 12d) that is closest to the specimen holding position;
**characterized in that** said final electrode defines at least one internal passageway (14, 14a, 14b, 14c, 14d, 14e, 14f, 18a, 18b) having a terminus (54) that is proximal to and directed toward the specimen holding position.

2. The assembly of claim 1, wherein:
said at least one internal passageway comprises a light pathway (14, 14a, 14b, 14c, 14d, 14e, 14f) and includes an additional terminus that houses a light detector; or
said at least one internal passageway comprises a gas pathway (18a, 18b) and includes an additional terminus that is connected to a gas source.

3. The assembly of claim 1, wherein:
said at least one internal passageway comprises a first light pathway and wherein said final electrode defines a second light pathway (14, 14a, 14b, 14c, 14d, 14e, 14f) in addition to said first light pathway; or
said at least one internal passageway comprises a first gas pathway and wherein said final electrode defines a second gas pathway (18a, 18b) in addition to said first gas pathway.

4. The assembly of claim 3, wherein:
said first light pathway terminates in a light source and said second light pathway terminates in a light detector; or
said first gas pathway terminates in a gas source and said second gas pathway terminates in a gas detector or a second gas source.

5. The assembly of claim 1, wherein said at least one internal passageway comprises both a gas pathway and a light pathway and includes a terminus that communicates with both a gas source and a light source.

6. The assembly of any of claims 1 - 5, wherein said final electrode is made of metal and wherein said internal passageway takes the form of a tubular void space in the metal.

7. The assembly of claim 6, wherein the metal comprises a titanium alloy.

8. The assembly of claim 6 or claim 7, wherein the surfaces of the void space are polished to increase reflection.

9. The assembly of any of claims 1 - 8, further comprising a light pipe extending through said at least one internal passageway.

10. A method of directing one or more of light or gas to a predetermined specimen position (16) that is so close to a plate electrode (12, 12a, 12b, 12c, 12d) that no oblique pathway exists under the plate electrode to a viable light source position, comprising:
emitting one or more of light or gas into one or more of a light pathway (14, 14a, 14b, 14c, 14d, 14e, 14f) or a gas pathway (18a, 18b);
**characterized by** providing one or more of the light pathway or the gas pathway through the plate electrode to the predetermined specimen position.

11. The method of claim 10, wherein an additional light path is provided to the predetermined specimen position and wherein the method further includes receiving light from the specimen through the additional light path.

12. The method of claim 10 or claim 11, wherein said light path is an interior void having polished surfaces, and wherein said light reflects from said polished surfaces as it travels to said specimen.

13. The method of any of claims 10 - 12, wherein the final electrode is made of a titanium alloy.

14. The method of any of claims 10 - 13, wherein at least one additional light path is provided and wherein light is emitted into the at least one additional light path.

15. The method of claim 10, wherein the gas pathway comprises a first gas pathway and wherein the gas comprises a first gas, and further wherein a second gas pathway is provided through the plate electrode to the predetermined specimen position
and a second gas is passed through the second gas pathway.
